Europäisches Patentamt

European Patent Office

Office européen des brevets

(11) Publication number: **0 483 436 A1**

# EUROPEAN PATENT APPLICATION

(21) Application number: **90480172.7**

(22) Date of filing: **31.10.90**

(51) Int. Cl.5: **G01R 23/15**, **H03K 5/26**

(43) Date of publication of application:
**06.05.92 Bulletin 92/19**

(84) Designated Contracting States:
**DE FR GB**

(71) Applicant: **International Business Machines Corporation**
**Old Orchard Road**
**Armonk, N.Y. 10504(US)**

(72) Inventor: **Ballatore, Daniel**
**373 Chemin du Figueret, Pont du Loup**
**F-06620 Goudon(FR)**

(74) Representative: **Tubiana, Max**
**Compagnie IBM France Département de Propriété Intellectuelle**
**F-06610 La Gaude(FR)**

(54) **Clock frequency tester.**

(57) Clock frequency tester for indicating whether the frequency of a clock (FB) has a value which is comprised within a predetermined range of values (FA-FA/n, FA + FA/n) around a reference frequency value (FA). The clock frequency tester includes a frequency mixer (100) which provides an output frequency FQ in accordance with the relation FQ = absolute value of (FA-FB) for FB remaining close to FA, and a divide-by-n circuit (101) which divides the frequency FA. The frequency tester further includes a phase frequency comparator (102) which has a first and second input lead F1 and F2 which are respectively connected to the output of the divide-by-n circuit (101) and to the output of the frequency mixer (100). The phase frequency comparator (102) generates an output signal Q2 which remains at a steady level whenever F1 input signal has a frequency value which is superior to that of the F2 input signal, that is to say when the FB frequency to be tested is comprised within the range of values (FA-FA/n, FA + FA/n) (for FB remaining close to FA). Since the factor n of the division can be easily adjusted, any desired degree of accuracy can be provided by the frequency tester of the invention.

FIG.1

This invention relates to timing arrangement circuits for electronic systems and more particularly to devices for testing the characteristics of a clock.

Devices for testing the timing arrangement circuits and more particularly the characteristics of the clocks provided by the latter circuits are of general interest in the data processing and communication fields.

In the data processing field, the general tendency is to improve the performance of the systems and to increase their speed, thus entailing the electronic components therein included be clocked at higher and higher speeds. The latter components are consequently used in a frequency range which is ever more close to their critical frequency limit, over which a disfunction of the latter is likely to appear. The clocks which are used to drive the electronic components included into a data processing system should therefore be closely checked in order to make sure that the electronic components are driven at a desired frequency range. Conversely, the technology of DRAM requires that a dynamic Random Access Memory be regularly refreshed in order to save its contents. In that case, the refreshing frequency should be checked to be inferior to the critical refreshing frequency of the DRAM, value under which the contents of a DRAM might unfortunately be destroyed.

In the data communication field, the transmission of data over telecommunication lines at higher and higher speed has also entailed in need in timing arrangement circuits and clocks having accurate and constant characteristics.

A need therefore exists in both the telecommunication and data processing fields for a device which tests the value of the frequency of a clock and particularly which determines whether the latter is comprised within a defined range of values. Further, it is desirable that the latter range of values be easily changed and adapted according to the desired degree of accuracy.

Summary of the invention

It is a object of the invention to provide a frequency tester which indicates whether the frequency of a clock has a value which is comprised within a predetermined range of values.

It is a further object of the invention to provide a frequency tester which allows an easy adjustment of the latter range of values.

It is another object of the invention to provide a simple and low cost frequency tester which checks the accuracy and the stability of a clock used in a data communication system or a data processing system.

These and other objects of the invention are provided by means of the clock frequency tester according to the invention which indicates whether the frequency of a clock (FB) has a value which is comprised within a predetermined range of values (FA-FA/n, FA + FA/N) around a reference frequency value (FA) of a reference clock. The clock frequency tester includes a frequency mixer which provides an output frequency FQ in accordance with the relation FQ = absolute value of (FA-FB) where FB remains close to FA, and a divide-by-n circuit which divides the frequency FB of the clock to be tested. The frequency tester further includes a phase frequency comparator which has a first and second input lead F1 and F2 which is respectively connected to the output of the divide-by-n circuit and to the output of the frequency mixer. The phase frequency comparator generates an output signal which remains at a steady level whenever F1 input signal has a frequency value which is superior to that of the F2 input signal, that is to say when the FB frequency to be tested is comprised within the range of values (FA-FA/n, FA + FA/n). Since the factor n of the division can be easily adjusted, any desired degree of accuracy can be provided by the frequency tester of the invention.

According to a preferred embodiment of the invention, the frequency mixer is a D-latch which has a clock-input connected to the FA reference clock and a D-input connected to the clock to be tested. The mixer therefore provides, for any frequency FB varying from zero to the infinite, an output signal which has frequency comprised between 0 and FA/2 in accordance with the relation: FQ = absolute value of (kxFA-FB) where k = 0, 1, 2, 3, ... The phase frequency comparator consequently entails the generation of a steady output level whenever the ratio FB/FA is inferior to 1/n or comprised within one range of values among the ranges (k-1/n, k + 1/n) where k = 1, 2, 3, ..., i.e. whenever the tested frequency has a frequency value being close to a multiple of FA.

According to another preferred embodiment of the invention, the frequency tester further includes a second (resp. a third phase frequency comparator) which has two input leads F'1 and F'2 (resp. F''1 and F''2) respectively receiving FA/2 and FB/3 (resp. FB and FA/2) and which provides a steady output signal whenever the frequency value of its former input F'1 (resp. F''1) is superior to that of the latter input F'2 (resp. F''2) that is to say whenever the ratio FB/FA is inferior to 1.5 (resp. is superior to 0.5). The output of every phase frequency comparator is combined in such a way as to provide an output signal QT which remains at a steady level whenever the FB/FA ratio is comprised within the range (1-1/n, 1 + 1/n) for FB varying from zero to the infinite.

Description of the drawings

Figure 1 illustrates the preferred embodiment of the invention.

Figure 2 details a negative edge triggered phase frequency comparator which is used in the preferred embodiment of the invention.

Figure 3 details a positive edge triggered phase frequency comparator which is used in the preferred embodiment of the invention.

Figure 4 details a divide-by-3 circuit which is used in the preferred embodiment of the invention.

Figure 5 shows a diagram illustrating the evolution of the output frequency of frequency mixer 100 with the ratio FB/FA.

Figure 6a details timing diagrams illustrating the operating of phase frequency comparator 102.

Figure 6b shows a diagram illustrating the evolution of the output frequency of comparator 102 with the ratio FB/FA.

Figure 6c shows a diagram illustrating the evolution of the output frequency Qt of AND gate 113 with the ratio FB/FA.

Figure 7 and 8 show typical timings illustrating how operates the frequency tester according of the present invention.

Description of the preferred embodiment of the invention

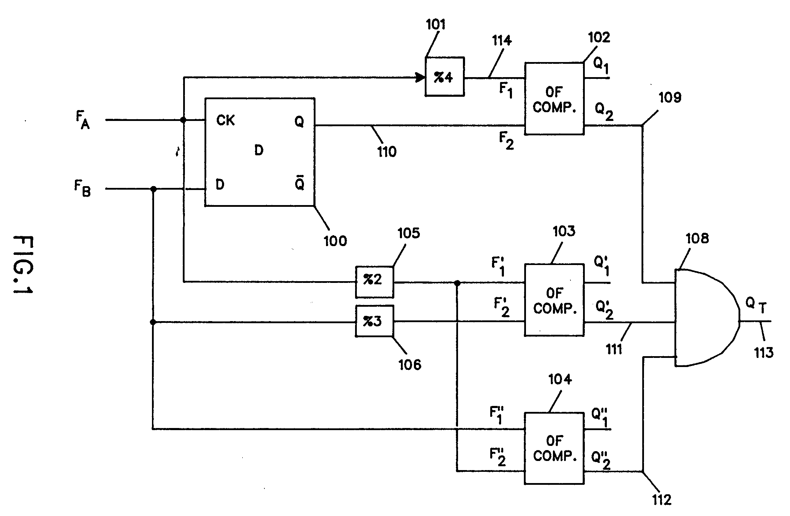

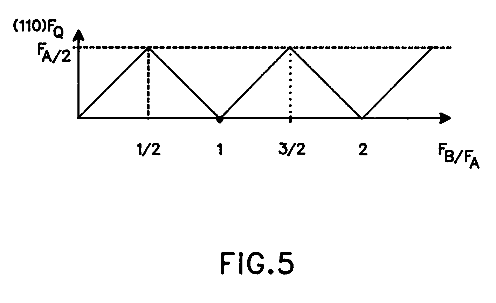

With respect to fig. 1, the clock frequency tester according to the invention includes a D-latch 100 which is used as a digital frequency mixer, that is to say receives the reference clock FA at its clock input and also receives the clock FB which is to be tested at its D-input lead. The Q output lead 110 of D-latch 100 provides a signal which has a frequency which is comprised between 0 and FA/2 according to the value of the ratio FB/FA and according to the following relationship: FQ = absolute value of (kxFA-FB) with k = 0, 1, 2, 3 ... (see figure 5). The reference clock FA is also transmitted to the input of a divide-by-n circuit 101, the output of which being connected to a F1 input lead 114 of a phase frequency comparator 102. Phase frequency comparator 102 has a second input lead F2 which is connected to the Q output of D-latch 100, lead 110.

Fa clock is also transmitted to a divide-by-2 circuit 105, the output of which being connected to a F'1 input lead of a second phase frequency comparator 103 and to a F''2 input lead of a third phase frequency comparator 104. FB clock is transmitted to the input of a divide-by-3 circuit 106 and to a F''1 input lead of the phase frequency comparator 104. The output of divide-by-3 circuit 106 is connected to a F'2 input lead of phase frequency comparator 103. The Q2, Q'2 and Q''2 output of respectively phase frequency comparator 102, 103 and 104 are connected each one to an input lead of an AND gate 108, the output of which carrying a QT signal on lead 113. As will be shown hereinafter, QT signal is representative of the FB/FA ratio and more particularly indicates whether the tested frequency FB has a value which is comprised within the range ( FA - FA/n ; FA + FA/n ) where n is the factor of division of divide-by-n circuit 101.

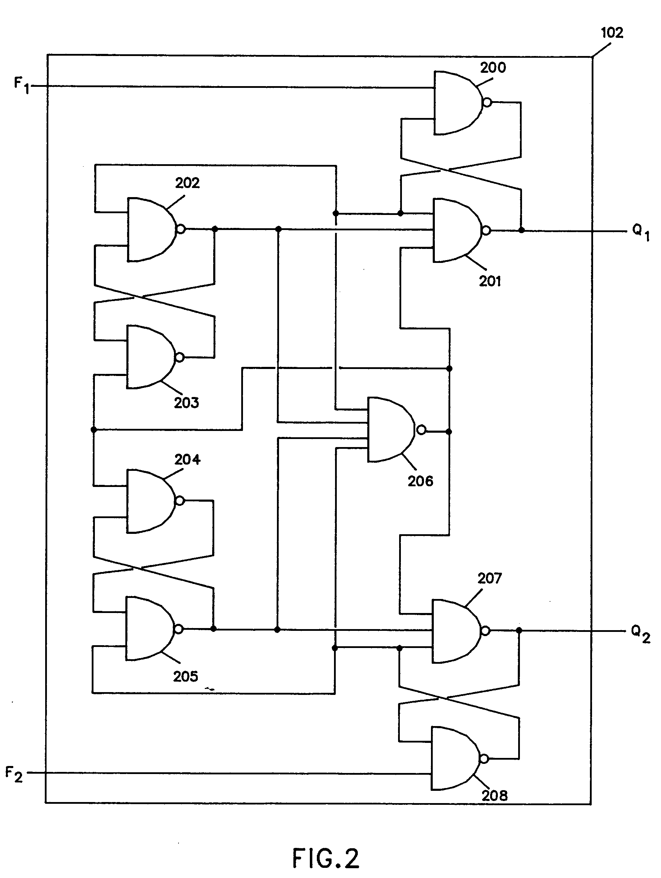

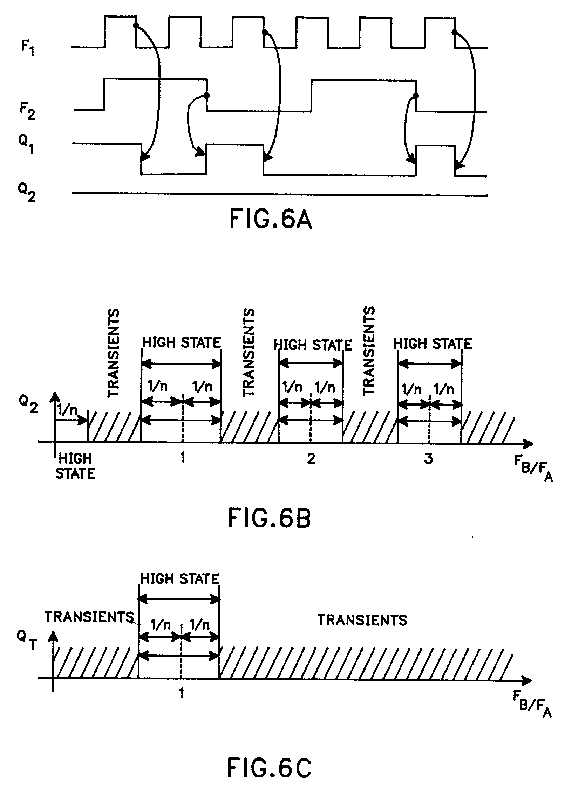

Positive or negative edge triggered phase frequency comparators can be used in order to embodiment comparators 102, 103 and 104. Figure 2 illustrates a negative edge triggered phase comparator 102 which is used in a preferred embodiment of the invention. Phase frequency comparator 102 (or 103, or 104) includes a set of 4 Set-Reset flip-flops 200-201, 202-203, 204-205 and 207-208 and a 4-input-NAND gate 206, the output of which being connected to the reset input of every Set-Reset flip-flop. More accurately, the F1 signal (resp. F'1 signal for comparator 103, F''1 signal for comparator 104) is transmitted to a first input of NAND gate 200, a second input of which being connected to the output of NAND 201. The output of NAND 200 is connected to a first input of NAND 201, to a first input of NAND 202 and to a first input of NAND 206. NAND 201 has a second input connected to the output of NAND 202, to a first input of NAND 203 and to a second input of NAND 206. NAND 201 has a third input connected to the output of NAND 206, to a second input of NAND 203 and to a first input of NAND 204. NAND 202 has a second input which is connected to the output of NAND 203. NAND 204 has a second input which is connected to the output of NAND 205, to a third input of NAND 206 and to a first input of NAND 207. NAND 204 has an output which is connected to a first input of NAND 205, a second input of which being connected to a fourth input of NAND 206, to a second input of NAND 207 and to the output of NAND 208. NAND 207 has a third input which is connected to the output of NAND 206 and an output which is connected to a first input of NAND 208. F2 signal (or F'2 for comparator 103, or F''2 for comparator 104) is transmitted to a second input of NAND 208. NAND gate 201 and NAND gate 207 respectively provides a Q1 and Q2 signal which are representative of the F1/F2 ratio. More accurately, whenever F2 is superior to F1, the output Q1 of NAND gate 201 remains at a high level while the output Q2 of NAND gate 207 is characterized by the existence of transitions. Conversely, whenever F1 is superior to F2, the output Q2 of NAND gate 207 remains at a high level while the output Q1 of NAND gate 201 is characterized by the existence of transitions. Figure 6A shows typical timings of the F1, F2, Q1 and Q2 illustrating the operating of negative edge triggered phase frequency comparator 102.

With respect to figure 6b, there is shown a diagram illustrating the evolution of the Q2 output signal when the FB/FA ratio varies. Because of the existence of D-latch 100 and divide-by-n circuit 101, the Q2 signal at the output of phase frequency comparator 102 remains at a high state when the ratio FB/FA is comprised in the following value ranges: (0, 1/n) ; (1-1/n, 1 + 1/n) ; (2-1/n, 2 + 1/n) ; (3-1/n, 3 + 1/n) ; etc... Divide-by-2 circuit 105 and divide-by-3 circuit 106 respectively provide a F'1 and F'2 signals which are transmitted to the two inputs of a second phase frequency comparator 103. The Q'2 output of the latter comparator therefore provides a steady high state whenever the FB/FA ratio is inferior to 1.5 The output of divide-by-2 circuit 105 is also connected to a F''1 input of a third phase frequency comparator 104, the F''2 input of which being connected to the tested FB clock. The Q''2 output of the third phase frequency comparator 104 therefore provides a steady high state whenever the FB/FA ratio is superior to 0.5. AND gate 108 which have three input leads respectively connected to the Q2, Q'2 and Q''2 output of comparators 102, 103 and 104, provides a QT signal on lead 113 which indicates whether the tested clock signal Fb is such that the FB/FA ratio is comprised within the range (1-1/n, 1 + 1/n).

With respect to figure 6c, there is shown a diagram illustrating the evolution of Qt output of AND gate 108 when the ratio FB/FA varies. It can be noticed that, as mentioned above, the QT signal remains at a steady high level whenever the latter ratio remains within the determined range of values. On the contrary, whenever the FB frequency decreases or increases with respect to the reference Fa frequency, transitions appear on the QT signal and consequently indicates a disfunction of the FB clock generator. The occurrence of that disfunction can easily be detected by storing the occurrence of a low state in QT signal in an appropriate (not shown in the figure) latch. It should be noticed that the range (1-1/n, 1 + 1/n) can be easily adapted and adjusted simply by changing the factor of division of divide-by-n circuit 101, thereby providing a very simple but accurate frequency tester.

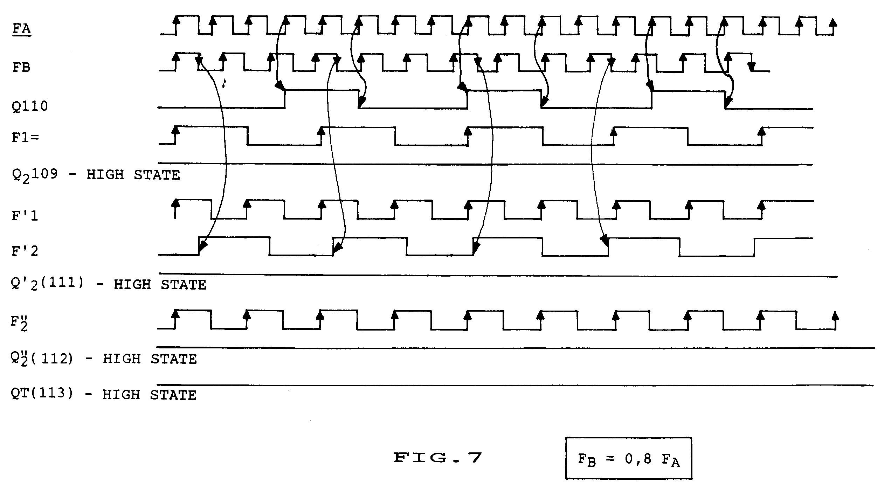

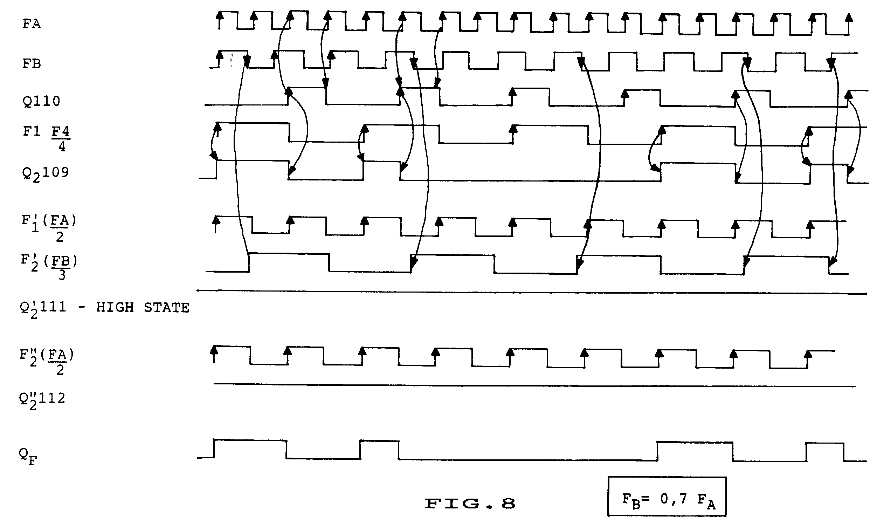

Figures 7 and 8 show typical timings illustrating how operates the frequency tester according to the present invention with a divide-by-4 circuit 101. Consequently the tester according to the present invention indicates by the existence of a steady high level at the output lead 113 of AND gate 108 whether the FB/FA ratio is comprised within the range (0,75; 1,25). Figure 7 particularly shows timings for a FB/FA ratio of 0,8 , that is to say for a value which is comprised within the preceding range (0,75; 1,25). There is shown the timings of FA, FB, Q output lead 110 of D-latch 100, F1, Q2 on lead 109, F'1, F'2, Q'2 on lead 111, Q''2 on lead 112 and QT on lead 113. It clearly appears that since FB/FA ratio is comprised within (0.75, 1.25), QT output signal on lead 113 remains at a steady high level state. On the contrary, figure 8 shows the corresponding timings for a FB/FA ratio of 0,7 , that is to say for a value which is not comprised within the range (0,75; 1,25). In this case, QT output lead 113 is characterized by the existence of transitions which are used in order to reset a (not shown) latch, the low level of which indicating a disfunction in the clock generators.

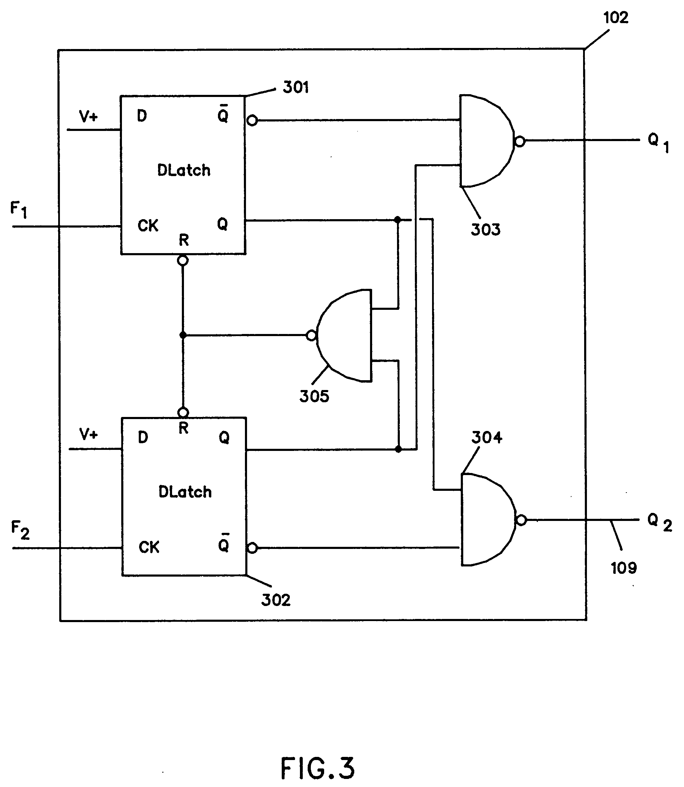

Figure 3 illustrates a positive edge triggered phase comparator which is used in a second preferred embodiment of phase frequency comparators 102, 103 and 104. Phase frequency comparator 102 includes a set of two D-latches 301 and 302 having their clock input respectively connected to F1 and F2 signals and their D-input connected to the positive voltage source V + . The Q output of D-latch 301 is connected to a first input of NAND gate 304 and to a first input of NAND 305. Similarly, the Q output lead of D-latch 302 is connected to a first input of NAND gate 303 and to a second input of NAND 305, the output of which being connected to the reset input leads of D-latches 301 and 302. D-latch 301 has a inverted Q output lead which is connected to a second input of NAND 303. D-latch 302 has an inverted Q output lead which is connected to a second input of NAND 304, the output of which providing the desired Q2 signal on lead 109 (resp. lead 111 for phase frequency comparator 103, lead 112 for phase frequency comparator 104).

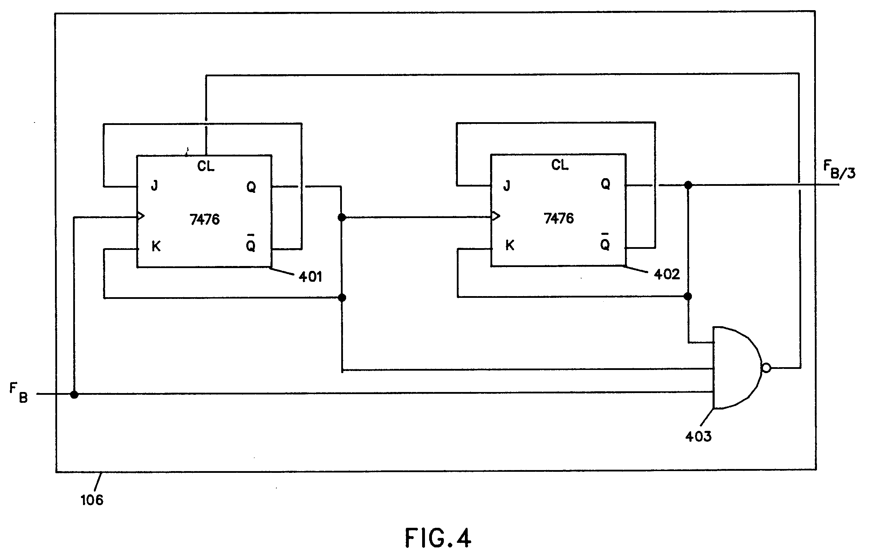

With respect to figure 4, there is described a preferred embodiment of divide-by-3 circuit 106 which consists of a negative edge triggered divide-by-3 circuit. Divide-by-3 circuit 106 is made up of a set of two J-K latches 401 and 402 well known in the art under the part number 7476. The FB clock is transmitted to the clock input of latch 401 and to a first input of a NAND gate 403, the output of which being connected to the clear input lead of latch 401. The Q output of the latter is connected to its K input lead, to the clock input of latch 402 and to a second input lead of NAND gate 403. The inverted Q output lead of latches 401 and 402 is respectively connected to the J-input lead of the latch 401 and 402. The Q output lead of latch 402 is connected to its K input lead, to a third input of NAND 403 and provides a clock which frequency has a value being equal to FB/3, with a 50% duty cycle.

## Claims

1. Clock frequency tester for determining whether the frequency of a clock (FB) has a value which is comprised within a predetermined range of values (FA-FA/n, FA + FA/N) around a reference frequency value (FA) of a reference clock, characterized in that it includes:
   - a frequency mixer (100) for providing an output signal (110) having a FQ frequency value in accordance with the relation:

   FQ = absolute value of (FA-FB) for FB comprised within (FA/2, 3xFA/2)
   - a divide-by-n circuit (101) for dividing the frequency FB of the clock to be tested,
   - a phase frequency comparator (102) having two input leads F1 and F2 (114, 110) respectively connected to the outputs of said divide-by-n circuit (101) and said mixer (100), said phase frequency comparator generating an output signal (109) which remains at a steady level whenever the output signal of said divide-by-n circuit (101) has a frequency which is superior to that of said mixer (100).

2. Clock frequency tester according to claim 1 characterized in that said frequency mixer (100) is a D-latch having its clock-input connected to said reference clock and its D-input connected to the clock to be tested and providing an mixed output signal (110) of a frequency comprised between 0 and FA/2 in accordance with the following relation:

   FQ = absolute value of (kxFA-FB) where k = 0, 1, 2, 3, ...

   whereby said phase frequency comparator generates a steady output level Q2 (109) when said ratio FB/FA is inferior to 1/n or comprised within one range of values of the ranges (k-1/n, k + 1/n) where k = 1, 2, 3, ...

3. Clock frequency tester according to claim 2 characterized in that it further includes:
   - a divide-by-2 circuit (105) connected to said reference clock FA,
   - a divide-by-3 circuit (106) connected to said tested clock FB,
   - a second phase frequency comparator (103) having a first input F'1 connected to the output of said divide-by-2 circuit and a second input F'2 which is connected to the output of said divide-by-3 circuit (106) for generating a steady output signal Q'2 (111) whenever the frequency of its first input signal F'1 is superior to that of its second input signal F'2,
   - means (108) for combining the output signals of said first and said second phase frequency comparators (102, 103) in order to provide a steady level when said FB/FA ratio is comprised within (0,1/n) or (1-1/n, 1 + 1/n).

4. Clock frequency tester according to claim 3 characterized in that it further includes:
   - a third phase frequency comparator (104) which has a first input lead F''1 connected to said tested clock FR and a second input lead F''2 which is connected to the output of said divide-by-2 circuit (105) for generating a steady output signal Q''2 (112) when the frequency of its first input signal F''1 is superior to that of its second input signal F''2,
   - means (108) for combining the output signals Q2, Q'2 and Q''2 of said first, said second and said third phase frequency comparator (102, 103 and 104) in order to provide an output signal having a steady level only when the FB/FA ratio is comprised within the range of values (1-1/n, 1 + 1/n).

5. Clock frequency tester according to claim 4 characterized in that said first, second and third phase frequency comparators are positive edge triggered comparators.

6. Clock frequency tester according to claim 5 characterized in that each of said first, second and third phase frequency comparator (102, 103, 104) includes a first (301) and a second (302) D-latches having their clock input respectively connected to said F1 and F2 signals and their D-input connected to a positive voltage source (V +), and

   said first D-latch (301) having a Q output which is connected to a first input of a first NAND gate (304) and to a first input of a second NAND gate (305),

   said second D-latch (302) having a Q output which is connected to a first input of a third NAND gate (303) and to a second input of said second NAND gate (305), said second NAND gate (305) having an output which is connected to the reset input lead of said first and said second D-latches (301) and (302),

   said first D-latch (301) having an inverted Q output lead which is connected to a second input of said third NAND gate (303),

said second D-latch (302) having an inverted Q output lead which is connected to a second input of said first NAND gate (304),

the output of said first NAND gate (304) providing a steady level when the frequency F1 is superior to the frequency F2.

7. Clock frequency tester according to claim 4 characterized in that said first, second and third phase frequency comparators are negative edge triggered comparators.

8. Clock frequency tester according to claim 7 characterized in that each of said first, second and third phase frequency comparators further includes a set of four Set-Reset flip-flops (200-201, 202-203, 204-205 and 206-207) and a 4-INPUT-NAND gate (206) which has a output connected to the reset input of every of said flip-flop.

9. Clock frequency tester according to claim 7 characterized in that each of said first, second and third phase frequency comparators further includes a first NAND gate (200) which has a first input connected to said F1 clock and a second input which is connected to the output of a second NAND gate (201), and

the output of said first NAND gate (200) being connected to a first input of said second NAND gate (201), to a first input of a third NAND gate (202), to a first input of a fourth NAND gate (206), and said second NAND gate (201) having a second input connected to the output of said third NAND gate (202) and to a second input of said fourth NAND gate (206) and to a first input of a fifth NAND gate (203), and

said second NAND gate (201) having a third input connected to the output of said fourth NAND gate (206), to a second input of said fifth NAND gate (203) and to a first input of a sixth NAND gate (204), and

said third NAND gate (202) having a second input which is connected to the output of said fifth NAND gate (203), and

said sixth NAND gate (204) having a second input which is connected to the output of a seventh NAND gate (205), to a third input of said fourth NAND gate (206) and to a first input of a eight NAND gate (207), and

said sixth NAND gate (204) having an output which is connected to a first input of said seventh NAND gate (205), said seventh NAND gate (205) having a second input which is connected to a fourth input of said fourth NAND gate (206) and to a second input of said eight NAND gate (207) and to the output of a ninth NAND gate (208), and

said eight NAND gate (207) having a third input which is connected to the output of said fourth NAND gate (206), and an output which is connected to a first input of said ninth NAND gate (208),

said ninth NAND gate having a second input connected to said F2 signal,

said eight NAND gate (207) providing said Q2 signal which remains at a steady level when said F1 signal has a frequency which is superior to that of said F2 signal.

10. Clock frequency tester according to claim 6 characterized in that said divide-by-3 circuit includes a first JK-latch (401) which has a clock input connected to said FB clock and to a first input of a fourth NAND gate (403), said third NAND (403) gate having an output which is connected to the clear input lead of said first JK-latch (401),

said JK-latch having a Q output which is connected to its K input lead, to the clock input of a second JK-latch (402) and to a second input lead of said third NAND gate (403),

said first and said second JK-latches (401) and (402) having an inverted output lead which is respectively connected to their J-input lead,

said second JK-latch (402) having a Q output which is connected to its K input lead, to a third input of said third NAND gate (403) and provides a divided-by-3 clock signal FB/3, with a 50% duty cycle.

FIG.1

FIG.2

FIG.3

FIG.4

EP 0 483 436 A1

FIG.5

FIG.6A

FIG.6B

FIG.6C

FA

FB

Q1 10

F1=

$Q_2$ 109 - HIGH STATE

F'1

F'2

Q'2 (111) - HIGH STATE

F''2

Q''2 (112) - HIGH STATE

QT (113) - HIGH STATE

$F_B = 0,8\ F_A$

FIG. 7

FA

FB

Q110

F1 $\frac{F4}{4}$

$Q_2$109

$F'_1(\frac{FA}{2})$

$F'_2(\frac{FB}{3})$

$Q'_2$111 - HIGH STATE

$F''_2(\frac{FA}{2})$

$Q''_2$112

$Q_F$

FIG.8

$F_B = 0,7\ F_A$

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-50744 (SIEMENS)<br>* abstract *<br>--- | 1 | G01R23/15<br>H03K5/26 |
| A | FR-A-2378285 (TE KA DE FELTEN & GUILLEAUME)<br>* page 1, line 34 - page 2, line 8 *<br>--- | 1 | |
| A | DE-B-2605380 (SIEMENS)<br>* figures 1, 2 *<br>----- | 1 | |

TECHNICAL FIELDS
SEARCHED (Int. Cl.5 )

G01R
G06F
H03K
H03H

The present search report has been drawn up for all claims

| Place of search | Date of completion of the search | Examiner |
|---|---|---|
| BERLIN | 21 JUNE 1991 | FRITZ S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)